# EUROPEAN PATENT APPLICATION

(11) **EP 4 749 890 A1**
(43) Date of publication of application: **27.05.2026**
(21) Application number: 25214049.6
(22) Date of filing: 06.11.2025
(51) Int. Cl.: H02K 5/20, B64U 50/19, H02K 9/06, H02K 11/33, H02K 1/18

(54) **PROPULSION UNIT**

(30) Priority: 20.11.2024 KR 20240165763
(71) Applicant: Hyundai Motor Company, Seoul 06797 (KR); Kia Corporation, Seocho-gu, Seoul 06797 (KR)
(72) Inventor: YOO, Hoan Ju, Hwaseong-si, Gyeonggi-do 18280 (KR); SHIN, Kwon Su, Hwaseong-si, Gyeonggi-do 18280 (KR); AN, Jeong Uk, Hwaseong-si, Gyeonggi-do 18280 (KR); LIM, Ki Tack, Hwaseong-si, Gyeonggi-do 18280 (KR); JANG, Yong Sok, Hwaseong-si, Gyeonggi-do 18280 (KR); YEO, Kyung Ku, Hwaseong-si, Gyeonggi-do 18280 (KR); KIM, Chee Mann, Hwaseong-si, Gyeonggi-do 18280 (KR); LEE, Kyung Jun, Hwaseong-si, Gyeonggi-do 18280 (KR); LEE, Kam Chun, Hwaseong-si, Gyeonggi-do 18280 (KR); JUN, Hyun Woo, Hwaseong-si, Gyeonggi-do 18280 (KR); LEE, Sung Ho, Hwaseong-si, Gyeonggi-do 18280 (KR); LEE, Jae Joon, Hwaseong-si, Gyeonggi-do 18280 (KR); LEE, Dong Su, Hwaseong-si, Gyeonggi-do 18280 (KR); HWANG, Yun Kyung, Hwaseong-si, Gyeonggi-do 18280 (KR); CHOI, Jong Hun, Hwaseong-si, Gyeonggi-do 18280 (KR); LEE, Hong Wook, Hwaseong-si, Gyeonggi-do 18280 (KR); JEUN, Jae Young, Hwaseong-si, Gyeonggi-do 18280 (KR)
(74) Representative: Isarpatent

(57) **Abstract**

A propulsion unit includes a stator, a rotor configured to rotate relative to the stator, a propeller connected to the rotor, an inverter electrically connected to the stator, a cooling housing that is disposed adjacent to the stator and the inverter and defines a cooling channel, a heat exchanger connected to the cooling channel, and one or more fans coupled to the rotor and configured generate airflow toward the heat exchanger through the cooling housing.

## Description

### TECHNICAL FIELD

The present disclosure relates to a propulsion unit including a stator, a rotor, an inverter, a cooling housing, and one or more fans.

### BACKGROUND

A mobility apparatus includes a means of transportation that can transport people or cargo by flying over the sky over a city using a propulsion unit. For instance, the propulsion unit of the mobility apparatus may include a propeller and a driving unit for rotating the propeller, where the driving unit may include a motor and an inverter for supplying power to the motor.

In some cases, the motor may include a stator and a rotor. The rotor may be connected to a shaft that is connected to the propeller. The rotor may be rotated by electromagnetic interaction with the stator, and the shaft and the propeller may rotate as the rotor rotates. When the motor operates, heat may be generated. If the heat is not dissipated, fatal damage may occur to the driving unit. In addition, heat may be also generated in the inverter, and a cooling unit may be provided to dissipate heat generated by the inverter as well as the motor.

For example, the propulsion unit may include a cooling unit and a cooling channel through which coolant flows. The coolant flowing through the cooling channel may exchange heat with heat generated by the motor and the inverter to dissipate heat generated by the propulsion unit. The cooling unit may include a heat exchanger for cooling the coolant. In some cases, when the heat exchanger and peripheral components thereof are installed, the weight of the mobility apparatus may increase, and drag loss may occur.

### SUMMARY

The present disclosure describes a propulsion unit that can reduce an increase in weight due to a heat exchanger and that can reduce drag loss.

According to one aspect of the subject matter described in this application a propulsion unit includes a stator, a rotor configured to rotate relative to the stator, an inverter electrically connected to the stator, a cooling housing that is disposed adjacent to the stator and the inverter and defines a cooling channel, a heat exchanger connected to the cooling channel, and one or more fans coupled to the rotor and configured to generate airflow toward the heat exchanger through the cooling housing.

Implementations according to this aspect can include one or more of the following features. For example, the one or more fans can include a first fan coupled to a first side of the rotor in an axial direction of the rotor, where the first fan and the cooling housing define a first portion of an airflow path toward the heat exchanger. In some examples, the one or more fans further can include a second fan coupled to a second side of the rotor in the axial direction, where the second fan and the cooling housing define a second portion of the airflow path toward the heat exchanger.

In some implementations, the one or more fans can include a first fan coupled to a first side of the rotor in an axial direction of the rotor, and a second fan coupled to a second side of the rotor in the axial direction, where the first fan, the cooling housing, and the second fan define an airflow path toward the heat exchanger. In some examples, the first fan, the cooling housing, and the second fan are arranged successively along the axial direction.

In some implementations, the cooling housing can include a hub, a rim portion disposed radially outside the hub, and an arm portion that connects the hub to the rim portion, where the airflow path includes an internal space that borders the hub, the rim portion, and the arm portion. In some examples, the cooling channel can be defined in the rim portion.

In some implementations, the first fan can overlap with the cooling housing along the axial direction. In some implementations, the first fan can overlap with the heat exchanger along the axial direction.

In some implementations, the rotor can include a shaft, a yoke coupled to the shaft, and a magnet disposed at the yoke, where the first fan is coupled to the shaft and configured to rotate with the shaft of the rotor. In some examples, the shaft can include a shaft body and a flange that extends from the shaft body in a radial direction of the shaft, where the first fan is fastened to the flange of the shaft.

In some implementations, the second fan can overlap with the heat exchanger along a radial direction of the rotor. In some examples, an inner surface of the heat exchanger can be inclined radially outward as the heat exchanger extends in the axial direction. In some examples, the heat exchanger can be positioned inside the second fan in the radial direction. In some examples, the second fan can be coupled to the yoke.

In some implementations, the yoke includes a convex portion that protrudes from an end of the yoke, and the second fan defines a concave portion that is recessed from an end of the second fan in the axial direction, where the convex portion of the yoke and the concave portion of the second fan overlap with each other in a radial direction of the rotor and are fastened to each other.

In some implementations, the first fan can be disposed forward relative to the cooling housing, and the second fan can be disposed rearward relative to the cooling housing. The second fan can include a second fan hub and a second blade that protrudes from the second fan hub, where the second fan hub can include a front air block protruding from an outer surface of the second fan hub, where the front air block is disposed forward relative to the second blade and protrudes radially outward relative to an outer circumferential surface of the yoke.

In some implementations, the front air block can overlap with the second blade in the axial direction. In some examples, an outer edge of the front air block can have an arch-shape.

In some implementations, the propulsion unit can further include a rear air block disposed at the heat exchanger, where the rear air block extends outward from the heat exchanger in a radial direction and overlaps with the second blade in the axial direction. In some examples, an outer end of the rear air block in the radial direction can be positioned radially outward relative to an outer end of the second blade in the radial direction.

In some implementations, the propulsion unit can further include a first sealing positioned between the yoke and the cooling housing in the axial direction, and a second sealing positioned between the flange and the cooling housing in the axial direction. In some implementations, the propulsion unit can further include a third sealing positioned between the shaft and the cooling housing in the axial direction. **In** some implementations, the propulsion unit can further include a fourth sealing positioned between the second fan and the cooling housing.

### BRIEF DESCRIPTION OF THE DRAWINGS

The above and other objects, features and advantages of the present disclosure will become more apparent to those of ordinary skill in the art by describing example embodiments thereof in detail with reference to the accompanying drawings.
FIG. 1 is a schematic view illustrating example modules of a movable mobility apparatus.
FIG. 2 is a view illustrating an example of a mobility apparatus.
FIG. 3 is a view illustrating an example of a mobility apparatus that implements a hovering mode.
FIG. 4 is a top view illustrating the mobility apparatus that implements the hovering mode.
FIG. 5 is a view illustrating an example of a mobility apparatus that implements a cruising mode.
FIG. 6 is a side cross-sectional view illustrating an example of a propulsion unit of the mobility apparatus.
FIG. 7 is a view illustrating an example of a cooling housing.
FIG. 8 is a view illustrating the cooling housing in which an inverter is disposed.
FIG. 9 is a view illustrating an example of a first fan disposed on a yoke.
FIG. 10 is a view illustrating an example of a second fan.
FIG. 11 is a view illustrating an example of an airflow generated by the first fan and the second fan.
FIG. 12 is a partially enlarged view of the second fan and an example of a heat exchanger.
FIG. 13 is a view illustrating an example of an airflow from the first fan to the heat exchanger and the second fan through the cooling housing.
FIG. 14 is a view illustrating an example of an airflow in the propulsion unit when a mobility apparatus takes off.
FIG. 15 is a view illustrating an example of an airflow in the propulsion unit when a mobility apparatus cruises.
FIG. 16 is a view illustrating an example of a coupling relationship between the yoke and the second fan.
FIG. 17 is a side cross-sectional view illustrating an example of the second fan including a front air block.
FIGS. 18A and 18B are views illustrating an example of a comparison between an airflow near the second fan without the front air block and an airflow near the second fan with the front air block.
FIG. 19 is a view illustrating an example of a partial area of the second fan including a rear air block.
FIG. 20 is a side cross-sectional view illustrating an example of the second fan including the rear air block.
FIGS. 21A and 21B are views illustrating an example of a comparison between an airflow near the second fan without the rear air block and an airflow near the second fan with the rear air block.
FIG. 22 is a view illustrating an example of the heat exchanger.
FIG. 23 is a view illustrating an example of a flow of coolant and a flow of air in the heat exchanger.

### DETAILED DESCRIPTION

Since the present disclosure can have various changes and various embodiments, specific embodiments are illustrated and described in the accompanying drawings. However, it should be understood that it is not intended to limit specific embodiments, and it should be understood to include all modifications, equivalents, and substitutes included in the spirit and scope of the present disclosure.

Hereinafter, embodiments will be described in detail with reference to the accompanying drawings, and the same or corresponding components are denoted by the same reference numeral regardless of the reference numerals, and overlapping descriptions thereof will be omitted.

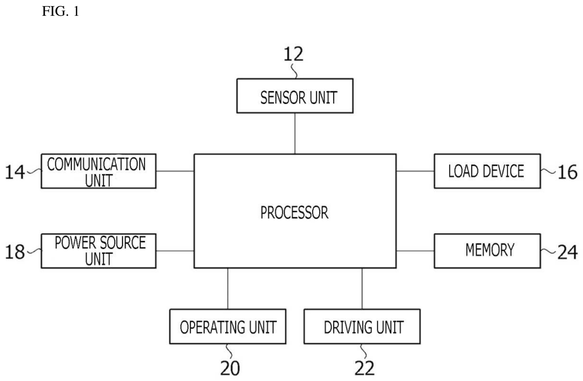

Hereinafter, FIG. 1 is a schematic view illustrating example modules of a movable mobility apparatus.

For example, a mobility apparatus 10 can be a mobile apparatus having mobility. The mobility apparatus 10 can load people, objects for a specific purpose, and/or cargo while moving from one point to a specific point. That is, the mobility apparatus 10 can move for transportation and other purposes, and the other purposes can include, for example, mounting an observation device to detect or monitor a surrounding environment of the mobility apparatus 10. More specifically, the mobility apparatus 10 can be provided with a camera to capture or analyze images of surrounding environments and transmit the captured or analyzed images to a predetermined device. The mobility apparatus 10 is not limited to the above example and can be used for various purposes.

Depending on space in which the mobility apparatus 10 moves, the mobility apparatus 10 can move in space related to the ground, underground, air, space, sea, and/or underwater. The mobility apparatus 10 for a ground or underground can be provided in the form of, for example, a vehicle, a robot, or the like, and the mobility apparatus 10 for air or space can be an aerial mobility and, for example, provided in the form of a conventional fixed-wing or rotary-wing aircraft, an advanced air mobility (AAM) that has been actively developed recently, an unmanned aircraft or drone, a rocket, a means of transportation mounted on an artificial satellite, or the like. The mobility apparatus 10 for sea or underwater can be, for example, a ship, a submarine, or the like. The mobility apparatus 10 can be a moving apparatus that is not limited to a specific space and can move in all of the above spaces, that is, a moving apparatus that can move to a plurality of spaces and, for example, can be an amphibious vehicle, a flying vehicle, or the like.

In addition, the mobility apparatus 10 can be moved through a manual operation, autonomy control, or a combination thereof. The manual operation can be implemented by a driver or an operator through an interface such as a control device provided on the mobility apparatus 10 or implemented by remote control by a control center or an external control center. The autonomy control, that is, autonomous movement, can be performed by independent processing of the mobility apparatus 10 or performed by a combination of remote control via the control center and collaborative processing of the mobility apparatus 10 with the control center or the like.

In some examples, the mobility apparatus 10 operated in various forms can be designed differently depending on a purpose, a movement space, a driving method, a control method, or the like, but can have common function modules as illustrated in FIG. 1 from a comprehensive perspective such as mobility. FIG. 1 mainly describes common functions of any type of mobility apparatus 10. Accordingly, although a function module used in each type may be omitted, implementations of the present disclosure may not exclude modules in which the mobility apparatus 10 is omitted in FIG. 1, and the modules are not excluded from the scope of the present implementation.

The mobility apparatus 10 can include a sensor unit 12, a communication unit 14, and a load device 16.

The sensor unit 12 can have any type of detector for detecting various states and situations occurring in external and internal environments of the mobility apparatus 10 and identifying position information of the mobility apparatus 10. That is, the sensor unit 12 can include different types of sensors and acquire sensing data detected from each sensor. The sensor unit 12 can acquire sensor data used for movement control, state data on detected states of modules constituting the mobility apparatus 10, situation data on detected situations of passengers and/or loads, and the like and provide the acquired data to a processor 26 for triggering a predetermined function and operation. In the present disclosure, the movement control can be at least one piece of operation control related to linear movement, turning, acceleration/deceleration, attitude control, braking, and hovering of the mobility apparatus 10, or the like. In the present disclosure, the hovering can be performing control so that the thrust is generated downward from or perpendicular to the mobility apparatus 10 to trigger the predetermined operation or movement of the mobility apparatus 10. The predetermined operation or movement can be, for example, takeoff, landing, or a substantially stationary flight within a limited range. The above data of the sensor unit 12 is merely illustrative and can additionally include sensor data on various detected situations not listed herein.

The communication unit 14 can support mutual communication with other devices to exchange data with other external devices. The other devices can be, for example, a server for controlling the mobility apparatus 10 or exchanging data related to the movement control of the mobility apparatus 10, an auxiliary device for supporting movement, another mobility apparatus, and the like. The server can be referred to as various terms, such as a control device, a management device, a control device, and the like. The communication unit 14 can transmit data generated or stored during movement to another device and receive data and software modules transmitted from another device. A protocol applied to the communication unit 14 can be determined according to the type of the mobility apparatus 10 and, for example, can communicate with another vehicle or another device based on cellular communication, wireless access in vehicular environment (WAVE) communication, dedicated short range communication (DSRC) or short-range communication, or other communication methods. The communication protocols and methods listed above are illustrative and are not limited thereto.

The load device 16 can be an auxiliary device that is mounted on the mobility apparatus 10 to consume power that is supplied from a power source unit 18 by a command for a user's usage or management of the load or converted from the output of the power source unit 18. In some cases, the load device 16 can be a type of non-mobile electric device that does not include a mobility power system used in the driving unit 22 and the like in the present disclosure. The load device 16 can be, for example, a display system, an air conditioning system, a lighting system, a seat system, various devices, or the like installed on the mobility apparatus 10.

In some examples, the mobility apparatus 10 can include an interface for receiving a request for movement control and the operation of the load device 16. The interface can be implemented as a hardware device, a software interface, or the like. The hardware interface is a hardware operating device for the movement operation that the user requests from the mobility apparatus 10 and can be, for example, an aircraft joystick, a ground steering wheel, ground pedals, buttons, a marine steering handler, or the like but is not limited thereto. The software interface can be, for example, a touch-enabled display but is not limited thereto.

In addition, the mobility apparatus 10 can include a power source unit 18, an operating unit 20, and a driving unit 22.

The power source unit 18 can generate and supply power and electric power used for a mobility power system, such as the driving unit 22, and the load device 16. The mobility apparatus 10 can generate energy by at least one of various energy sources. When the mobility apparatus 10 is driven based on electric energy, the power source unit 18 can be composed of, for example, an electric battery or a combination of the electric battery and a charging module for charging the battery. When the power source unit 18 is composed of only the electric battery, the electric battery can be charged from a charging station or another mobility apparatus to supply power. When the power source unit 18 is composed of a combination of the electric battery and the charging module, the power source unit 18 can adopt at least one of a fuel cell and a fossil energy-based engine as a charging module. The fuel cell can use a material used to produce electricity, such as hydrogen gas. When the power source unit 18 is an engine, the power source unit 18 has a generator coupled with the engine, and the generator can convert mechanical energy generated by the engine into electrical energy and charge the electric battery with the converted electrical energy.

As another example, when the mobility apparatus 10 is driven based on fossil energy or nuclear fuel, the power source unit 18 can be composed of an internal combustion engine, a turbine engine, a nuclear fuel-based engine, or the like. As still another example, the mobility apparatus 10 can have the power source unit 18 in a hybrid form of a fossil fuel-based engine and an electric battery. The hybrid power source unit 18 can charge the electric battery using an output of the engine generated during movement, select one of power of the engine or power of the electric battery depending on states of the mobility apparatus 10, attributes of the movement path, movement situations, or the like, and generate a movement driving force of the driving unit 22. As another example, the hybrid power source unit 18 can include an electric battery capable of being charged by an external source and an engine. The processor 26 can switch between the power of the engine and the power of the electric battery depending on various situations and states to apply energy to the driving unit 22, and thus the movement driving force can be generated.

The operating unit 20 and the driving unit 22 can form an actuating unit for transmitting power generated by the power source unit 18 to externally implement a predetermined movement motion. **In** the present disclosure, the actuating unit is referred to as an actuator, and these terms can be used interchangeably and described.

The operating unit 20 can have at least one module that implements a movement operation. When the mobility apparatus 10 is a mobility apparatus, the operating unit 20 can have mechanical and software components for performing at least one operation among, for example, control of flight attitudes such as a roll, yaw, and pitch of the mobility apparatus 10, hovering control related to takeoff and landing, and flap control for a change in altitude and a turning operation. When the mobility apparatus 10 is a ground mobility, the operating unit 20 can have a mechanical and software component for implementing at least one driving operation among, for example, longitudinal control, such as acceleration and deceleration, and transverse control such as steering. The operating unit 20 of the ground mobility can include a module for transmitting power from the power source unit 18 to the driving unit 22 and a module for converting power transmitted to the driving unit into power having a predetermined size and form.

The driving unit 22 is a module for externally implementing linear movement, turning, acceleration/deceleration, attitude control, braking, hovering, or the like of the mobility apparatus 10 and can be implemented in various forms depending on the type of the mobility apparatus 10. When the mobility apparatus 10 is a typical mobility apparatus, the moving driving unit of the fixed-wing mobility apparatus can be a turbine engine, a flap, or the like that is installed on a main wing, a tail wing, and the like to implement the operation related to the thrust and lift of the mobility apparatus. As another example, the fixed-wing mobility apparatus can further include a propulsion unit, such as a propeller, on a predetermined part of the main wing. The driving unit 22 of the typical rotary-wing mobility apparatus can be a rotor-type propulsion unit, flap, or the like that is installed on an upper portion of a fuselage and a tail wing. The typical mobility apparatus can have wheels, such as a landing gear for takeoff and landing, depending on the specifications, and the wheels can be accommodated in the fuselage during flight. The AAM type driving unit 22 can have a rotor type propulsion unit and flap similar to the rotary-wing mobility apparatus. A propulsion unit applied to the AAM type driving unit 22 can be fixed to at least the main wing to not tilt or installed on at least the main wing to tilt. As another example, the propulsion unit applied to the AAM type driving unit 22 can be installed as a plurality of propulsion units in the main wing. In addition, the AAM type driving unit 22 can be configured to rotate wings to which the propulsion unit is coupled within a predetermined angle range. The AAM type driving unit 22 can have wheels, such as a landing gear, which are accommodated in a fuselage during flight and are drawn out during takeoff and landing, depending on specifications. When the AAM type mobility apparatus is driven based on electric energy, the driving unit 22 can mainly include a motor and an inverter that use electric power to rotate the propeller. When the AAM type mobility apparatus is driven based on non-electric energy, such as fossil energy, the driving unit 22 can mainly be composed of modules for transmitting a rotational force generated by an internal combustion engine to the propeller.

When the mobility apparatus 10 is a ground mobility apparatus, the driving unit 22 can include a plurality of wheels, a driving force transmission module for generating a driving force to apply or transmit the driving force to wheels, a braking module for decelerating the driving of the wheels, a steering module for implementing transverse control of the wheels, and the like. The wheels, the driving force transmission module, the braking module, and the like can be formed as a driving assembly, and the driving assembly can be provided as a plurality of driving assemblies depending on the number of wheels.

When the mobility apparatus 10 is driven based on electric energy, the driving force transmission module can be formed as a motor module for generating a driving force based on power output from an electric battery.

In addition, the mobility apparatus 10 can include a memory 24 and the processor 26.

The memory 24 can store an application and various types of data for controlling the mobility apparatus 10 and load the application or read or write the data by the request of the processor 26. The application and data can vary depending on the type and specific specifications of the mobility apparatus 10 and include sensor data related to movement control, state data of the mobility related to movement control, data received from other devices, and data related to energy control between the power source unit 18 and the driving unit 22. In addition, the application and data can include data related to the control of a module in charge of a function other than the above control, software related to the operation of a computing system of a mobility, information and applications for autonomous movement, route information, various types of information and control programs for boarding convenience, and the like.

In relation to the present disclosure, the processor 26 can process movement control, route control, energy control, control of the load device 16, autonomous movement control, convenience function control, and the like using the application, instructions, and data that are stored in the memory 24. The processor 26 can also have different control processes depending on the type and specific specifications of the mobility apparatus 10. The processor 26 can be, for example, implemented as a single processing module. In another example, the processing according to the above matters can be processed in a distributed manner in a plurality of processing modules, and a plurality of processing modules in the present disclosure can be collectively referred to as the processor 26.

In the present disclosure, among various types of mobility apparatuses, the AAM type mobility apparatus is mainly described. Although the AAM type mobility apparatus is described, when the functions, modules, and devices of the mobility apparatus described in the present disclosure can be technically combined, they can be applied to other types of mobility apparatuses. In a broad sense, when the functions, modules, and devices of the mobility apparatus described in the present disclosure can be technically combined, they can be applied to mobility apparatuses for a ground, underground, space, sea, and underwater.

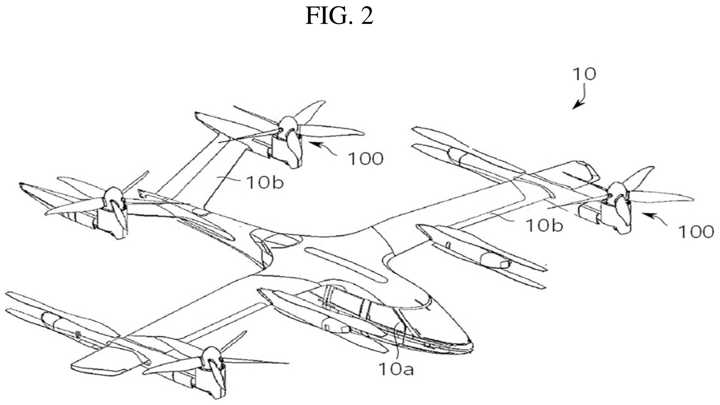

FIG. 2 is a view illustrating an example of a mobility apparatus.

In some implementations, the mobility apparatus 10 can include a streamlined fuselage 10a and wings 10b, such as a main wing and a tail wing, connected to the fuselage 10a. The fuselage 10a can have, for example, a cabin for a pilot and passengers and a space in which cargo is loaded.

A plurality of propulsion units can be disposed on the wings 10b, and each of the propulsion units 100 can include a propeller, a motor for rotating the propeller, an inverter for adjusting power of the power source unit 18 based on flight situations, motor specifications, or the like or converting a power form, and a cooling unit for cooling heat generated by the motor and the inverter. The propellers can be arranged parallel to the fuselage 10a.

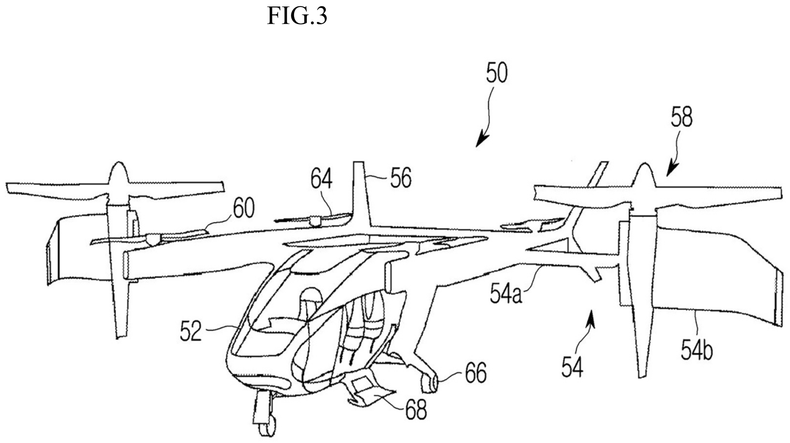

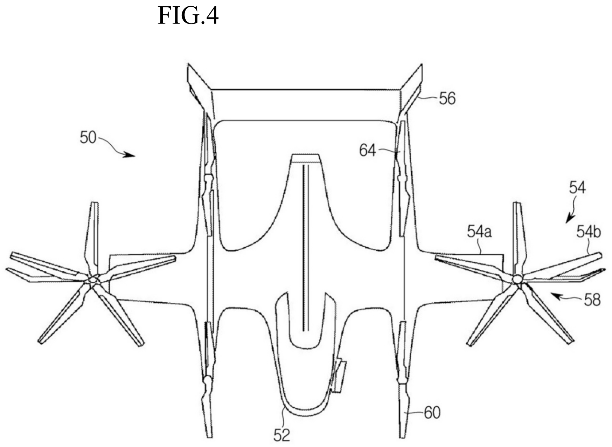

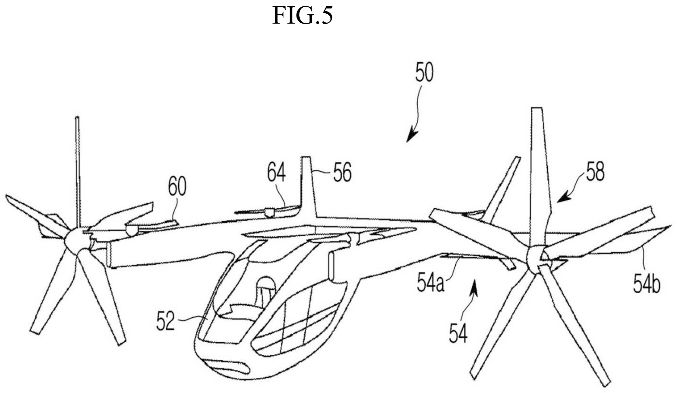

A mobility apparatus will be described with reference to FIGS. 3 to 5. FIG. 3 is a view illustrating an example of a mobility apparatus that implements a hovering mode. FIG. 4 is a top view illustrating the mobility apparatus that implements the hovering mode. FIG. 5 is a view illustrating an example of a mobility apparatus that implements a cruising mode.

The mobility apparatus of FIGS. 3 to 5 is substantially similar to the implementation shown in FIG. 2 except for a specific configuration of tilting propulsion. Hereinafter, the description of the same functions and members as those of FIG. 2 will be omitted, and the mobility apparatus will be described by focusing on a difference from FIG. 2.

In some implementations, a mobility apparatus 50 can include a fuselage 52, main wings 54 disposed at left and right sides of a central area of the fuselage 52, and a tail wing 56 connected to rods perpendicular to an extension direction of the main wings 54 and disposed in an end area of the fuselage 52.

The main wing 54 can have an inboard area and an outboard area. Tilting propulsion units 58 having a tilting rotor can be disposed in the front areas of left and right outboards. The tilting propulsion unit 58 can be fixed to the main wing by a boom provided in the outboard area of the main wing. Non-tilting propulsion units 60 and 64 disposed in a horizontal direction of the fuselage 52 can be disposed in the front and rear areas of the extended rods in the left and right inboard areas and can be referred to as lift propulsion units.

Meanwhile, the outboard area of the main wing 54 can be partitioned from a horizontal surface 54a of the inboard area to have a lift surface 54b, and the tilting propulsion unit 58 can be mounted on a boom protruding from the lift surface. The lift surface 54b can have a winglet bent from an end of the wing. For example, the tilting propulsion unit 58 and the lift surface 54b can be configured to rotate or move together. In some implementations different from that of FIGS. 3 to 5, when the lift surface 54b has a structure separated from the boom, the tilting propulsion unit 58 can move or rotate along with the lift surface except for a part of the lift surface 54b including the fuselage 52. In some implementations, the tilting propulsion unit 58 can be operated so that only a hub and blades move or rotate.

According to the above description, when a flight mode is a hovering mode, as illustrated in FIGS. 3 and 4, the tilting propulsion unit 58 can tilt substantially parallel to a blade arrangement direction of the non-tilting propulsion units 60 and 64. When the flight mode is a cruising mode according to horizontal flight or the like, as illustrated in FIG. 5, the tilting propulsion unit 58 can tilt at a predetermined angle with respect to the blade arrangement direction of the non-tilting propulsion units 60 and 64.

In some examples, the mobility apparatus 50 can include an extendable or non-extendable gear 66 for landing on the ground and/or water. The gear 66 can be disposed on both the front and rear of the mobility apparatus 50 and can include wheels, treads, pontoons, or other components capable of assisting the mobility apparatus in landing on land and/or water. In addition, the mobility apparatus 50 can have a stepper 68, which can be drawn out of the fuselage 52 when a passenger gets on or off, and a side door.

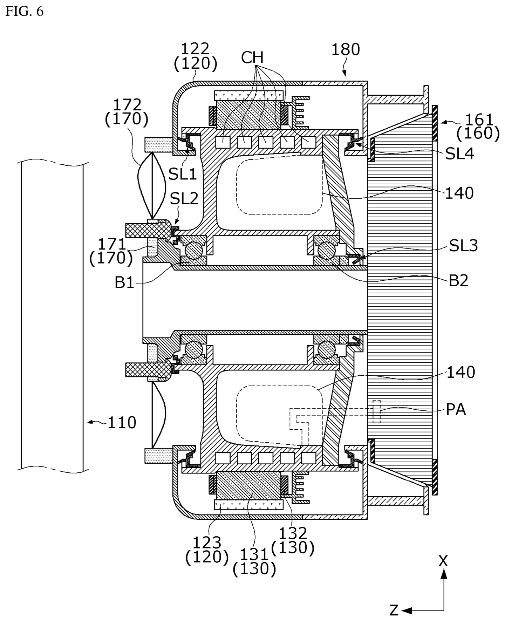

FIG. 6 is a side cross-sectional view illustrating an example of a propulsion unit 100 of a mobility apparatus.

In some implementations, referring to FIG. 6, the propulsion unit 100 of the mobility apparatus can include a propeller 110, a rotor 120, a stator 130, an inverter 140, a cooling housing 150, and a heat exchanger 161. Hereinafter, an axial direction of the propulsion unit 100 is a longitudinal direction of a shaft 121, and a radial direction is a direction perpendicular to the axial direction. Hereinafter, in the drawing, a z-axis refers to the axial direction, and an x-axis refers to the radial direction.

The propeller 110 is coupled with the shaft 121 of the rotor 120, and when the rotor 120 rotates, the propeller 110 also rotates and generate lift.

The shaft 121 can include a hollow shaft body 121a and a flange 121b. The flange 121b can be formed to extend radially from one axial end of the shaft body 121a.

The rotor 120 can include the shaft 121, a yoke 122, and a magnet 123. The yoke 122 can be a cylindrical member having one open side in the axial direction. The shaft 121 can be coupled to an upper portion of the yoke 122. In addition, the magnet 123 can be fixed to an inner surface of a side portion of the yoke 122. The magnet 123 can be formed by combining a plurality of split magnets or can be a single ring-shaped magnet.

The stator 130 can be fixed to the cooling housing 150. The stator 130 is positioned to face the rotor 120. The stator 130 can be positioned radially inside the rotor 120. That is, the rotor 120 can be disposed outside the stator 130. Here, the term "inward" refers to a direction toward the shaft 121 based on the radial direction, and the term "outward" refers to a direction away from the shaft 121 based on the radial direction.

The stator 130 can include a stator core 131 and a coil 132 wound around the stator core 131.

The inverter 140 can be fixed to the cooling housing 150. In addition, the inverter 140 can be positioned inside the stator 130. That is, the inverter 140 can be disposed to overlap the stator 130 in the radial direction. The inverter 140 can be disposed closer to an axial center of the propeller 110 than the stator 130 in the radial direction. In this way, since the inverter 140 is disposed between the stator 130 and the shaft 121 in the radial direction, it is possible to greatly reduce the size of the propulsion unit 100 in the axial direction.

The cooling housing 150 is disposed outside the shaft 121. In addition, the cooling housing 150 is positioned inside the stator 130. The cooling housing 150 can include a plurality of cooling channels CH. The cooling channels CH can be positioned radially between the stator 130 and the inverter 140. The cooling housing 150 is fixed to not rotate unlike the shaft 121. Bearings B1 and B2 can be fixed to the cooling housing 150. The bearings B1 and B2 rotatably support the shaft 121. The bearings B1 and B2 can include an upper bearing B1 and a lower bearing B2. The upper bearing B1 can be disposed on an upper portion of the cooling housing 150, and the lower bearing B2 can be disposed on a lower portion of the cooling housing 150.

The cooling unit 160 can include a heat exchanger 161. The cooling channels CH are connected to the heat exchanger 161. Coolant of the cooling channels CH are transferred to the heat exchanger 161 through a pump PM of the cooling unit 160. The coolant transferred to the heat exchanger 161 is cooled by heat exchange in the heat exchanger 161.

The heat exchanger 161 can be disposed just behind the rotor 120. Hereinafter, the term "forward" refers to a direction toward the propeller 110 based on the axial direction. In addition, the term "rearward" refers to a direction opposite to the direction toward the propeller 110 based on the axial direction.

Since the heat exchanger 161 is formed integrally with the rotor 120 and is disposed just behind the rotor 120, it is possible to reduce the size and weight of the propulsion unit 100. In particular, since the heat exchanger 161 is disposed just behind the rotor 120 and disposed to overlap the cooling housing 150 in the axial direction, the drag loss of the mobility apparatus can be greatly reduced by aerodynamically smoothing a flow on the surface of the propulsion unit.

In addition, since the heat exchanger 161 is positioned adjacent to the cooling housing 150, air passing through the cooling housing 150 can be guided to flow directly toward the heat exchanger 161, thereby greatly improving heat dissipation performance. In consideration of a structure of the propulsion unit 100 in which the cooling housing 150 is positioned between the stator 130 and the shaft 121, the heat exchanger 161 can greatly increase the heat dissipation performance of the propulsion unit 100.

A first fan 170 can be disposed in front of the cooling housing 150. The first fan 170 can be coupled to the flange 121b of the shaft 121. The first fan 170 is disposed to overlap the cooling housing 150 in the axial direction. When the first fan 170 rotates, the first fan 170 suctions air and transfers the suctioned air toward the cooling housing 150.

The second fan 180 can be disposed behind the cooling housing 150. The second fan 180 can be coupled to the yoke 122. The second fan 180 is disposed to overlap the cooling housing 150 in the axial direction. The second fan 180 suctions air passing through the cooling housing 150 and guides the air to flow into the heat exchanger 161 and discharges the air supplied to the heat exchanger 161 to the outside of the propulsion unit 100.

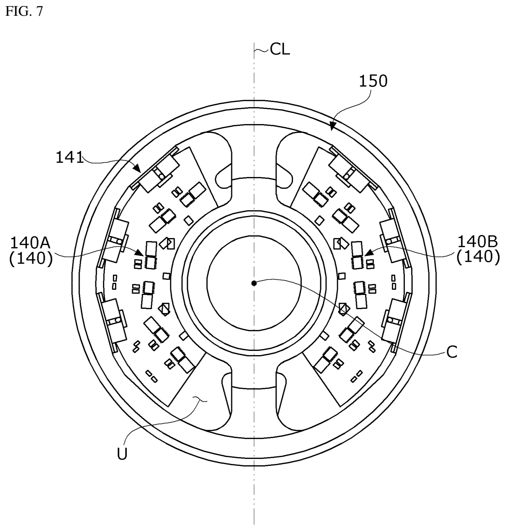

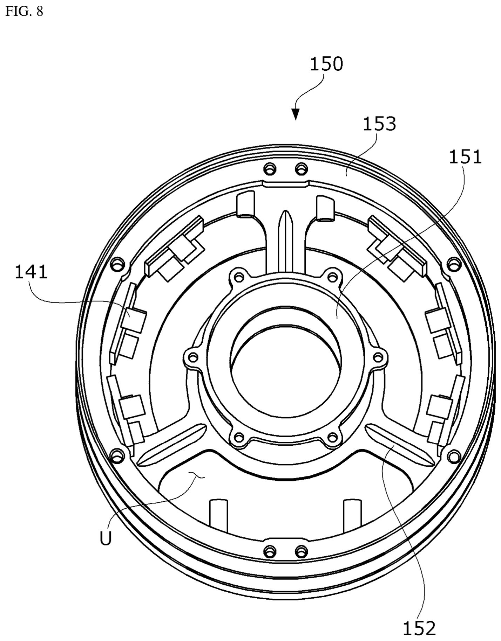

FIG. 7 is a view illustrating an example of the cooling housing 150, and FIG. 8 is a view illustrating the cooling housing 150 in which the inverter 140 is disposed.

Referring to FIGS. 7 and 8, the cooling housing 150 can include a cylindrical hub 151, arm portions 152 extending radially from the hub 151, and a rim portion 153 connected to the arm portions 152. The cooling channels CH can be formed inside the rim portion 153. The cooling channel CH is a space in which coolant flows into an empty space of the cooling housing 150 formed along the rim portion 153. The cooling channel CH can be provided as a plurality of cooling channels.

The stator 130 is fixed in contact with an outer circumferential surface of the rim portion 153. The inverter 140 can be positioned inside the rim portion 153. Among components of the inverter 140, a component 141 that generates much heat can be fixed to the rim portion 153 in direct contact with an inner circumferential surface of the rim portion 153.

The hub 151, the rim portion 153, and the arm portions 152 can form a flow path U through which air flows. The adjacent rim portions 153 in a circumferential direction can be spaced apart from each other so that a space is formed between the rim portions 153, and such a space can form the flow path U through which air suctioned by the first fan 170 flows and can border the hub 151, the rim portion 153, and the arm portions 152.

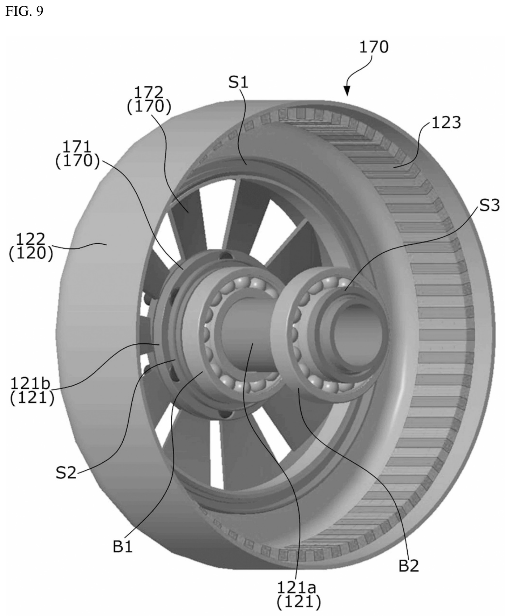

FIG. 9 is a view illustrating an example of the first fan 170 disposed on the yoke 122.

Referring to FIGS. 6 and 9, the first fan 170 can include a first fan hub 171 and a plurality of first blades 172 radially connected to the first fan hub 171. The first fan hub 171 is fastened to the flange 121b of the shaft 121. The first blade 172 can be connected to the yoke 122. The magnet 123 can be installed on an inner circumferential surface of a side wall of the yoke 122. When the yoke 122 is rotated by the electromagnetic interaction between the magnet 123 and the coil of the stator 130, the first fan 170 rotates together centered on the shaft 121.

A front sealing structure of the periphery of the first fan 170 is as follows.

A space is formed between the rotating yoke 122 and the fixed cooling housing 150. Foreign substances can flow into the space in which the stator 130 or the magnet 123 is positioned through such a space. A first sealing member S1 is disposed between the yoke 122 and the cooling housing 150 to prevent foreign substances from flowing into a gap between the yoke 122 and the cooling housing 150. The first sealing member S1 can be formed in a ring shape and can be in contact with the yoke 122 and the cooling housing 150 in the axial direction to fill the gap between the yoke 122 and the cooling housing 150. In addition, the first sealing member S1 can be in contact with the yoke 122 and the cooling housing 150 in the radial direction to fill the gap between the yoke 122 and the cooling housing 150.

In addition, a separation distance is also formed between the rotating flange 121b and the fixed cooling housing 150. Foreign substances can flow into the space in which the stator 130 or the magnet 123 is positioned through such a space. A second sealing member S2 is disposed between the yoke 122 and the cooling housing 150 to prevent foreign substances from flowing into a gap between the yoke 122 and the cooling housing 150. The second sealing member S2 can be formed in a ring shape and can be in contact with the flange 121b and the cooling housing 150 in the axial direction to fill the gap between the flange 121b and the cooling housing 150. In addition, the second sealing member S2 can be in contact with the flange 121b and the cooling housing 150 in the radial direction to fill the gap between the flange 121b and the cooling housing 150.

A front sealing structure of the periphery of the second fan 180 is as follows.

A separation space is also formed between an end portion of the rotating shaft 121 and the cooling housing 150. A third sealing member S3 is disposed between the end portion of the shaft 121 and the cooling housing 150 to prevent foreign substances from flowing into the gap between the shaft 121 and the cooling housing 150. The third sealing member S3 can be formed in a ring shape and can be in contact with the end portion of the shaft 121 and the cooling housing 150 in the axial direction to fill the gap between the end portion of the shaft 121 and the cooling housing 150. In addition, the third sealing member S3 can be in contact with the end portion of the shaft 121 and the cooling housing 150 in the radial direction to fill the gap between the end portion of the shaft 121 and the cooling housing 150.

As illustrated in FIG. 6, a separation space is also formed between the rotating second fan 180 and the cooling housing 150. A fourth sealing member S4 is disposed between the second fan 180 and the cooling housing 150 to prevent foreign substances from flowing into a gap between the second fan 180 and the cooling housing 150. The fourth sealing member S4 can be formed in a ring shape and can be in contact with the second fan 180 and the cooling housing 150 in the axial direction to fill the gap between the second fan 180 and the cooling housing 150. In addition, the fourth sealing member S4 can be in contact with the second fan 180 and the cooling housing 150 in the axial direction to fill the gap between the second fan 180 and the cooling housing 150.

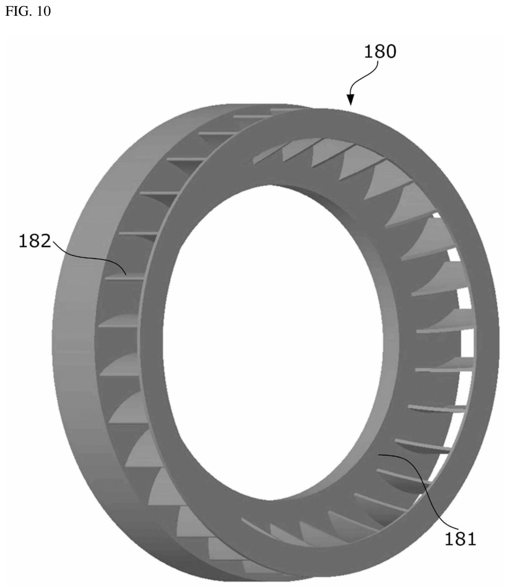

FIG. 10 is a view illustrating an example of the second fan180.

Referring to FIG. 10, the second fan 180 can be disposed behind the cooling housing 150 and can include a second fan hub 181 and a plurality of second blades 182 radially connected to the second fan hub 181. The second fan hub 181 is coupled to the yoke 122. The second fan 180 rotates along with the yoke 122.

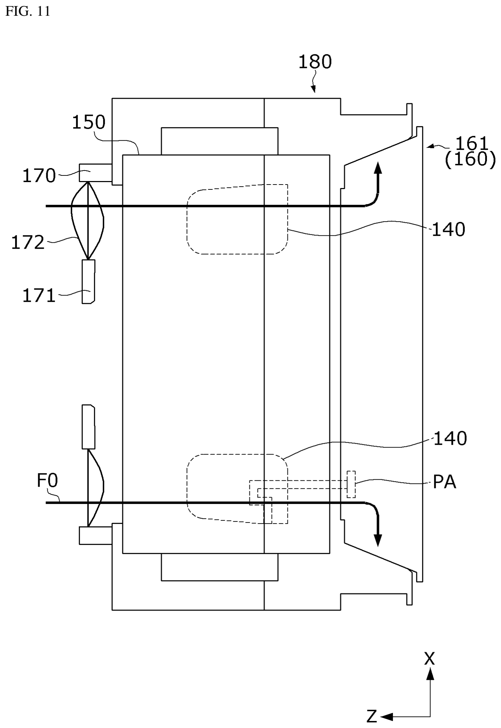

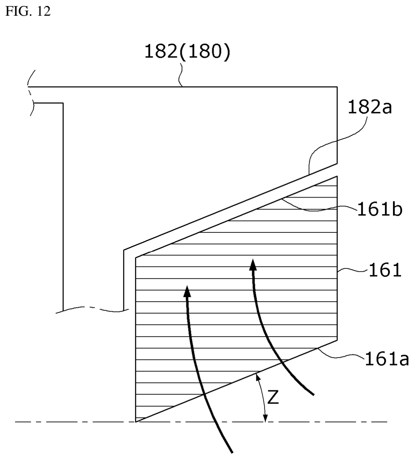

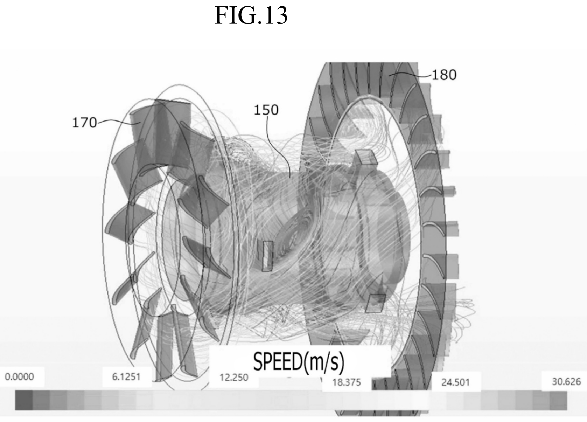

FIG. 11 is a view illustrating an example of an airflow generated by the first fan 170 and the second fan 180, FIG. 12 is a partially enlarged view of the second fan 180 and the heat exchanger 161, and FIG. 13 is a view illustrating an example of a flow of air flowing from the first fan 170 to the heat exchanger 161 and the second fan 180 through the cooling housing 150.

Referring to FIGS. 11 and 12, the first fan 170, the cooling housing 150, and the second fan 180 are disposed to overlap each other in the axial direction. In addition, the second fan 180 is disposed to overlap the heat exchanger 161 in the radial direction. The heat exchanger 161 can be positioned radially inside the second fan 180. When the yoke 122 rotates, the first fan 170 and the second fan 180 rotate, and the cooling housing 150 is fixed. Air F0 suctioned by the first fan 170 is guided to the cooling housing 150, and air passing through the cooling housing 150 flows to the heat exchanger 161. The air passing through the heat exchanger 161 and exchanging heat with the coolant of the heat exchanger 161 is suctioned by the second fan 180 and discharged to the outside. Since the second fan 180 is positioned radially outside the heat exchanger 161, a flow direction of air moving in the axial direction and suctioned into the heat exchanger 161 changes in the radial direction, and the air is suctioned into the second fan 180 and discharged to the outside.

In this way, since air suctioned into the first fan 170 flows directly into the heat exchanger 161, and air flowing into the heat exchanger 161 is suctioned directly by the adjacent second fan 180, a flow amount and flow rate of air flowing into the heat exchanger 161 are great. Accordingly, the heat dissipation performance of the propulsion unit 100 is high.

The heat exchanger 161 can be a ring-shaped member including an inner surface 161a and an outer surface 161b. The outer surface 161b is positioned to face an edge of the second blade 182 of the second fan 180. The outer surface 161b can be inclinedly formed to correspond to the inclined edge of the second blade 182. The inner surface 161a of the heat exchanger 161 can be formed to be axially inclined outward in the radial direction at a predetermined angle Z based on the axial direction.

In this way, when the inner surface 161a of the heat exchanger 161 is formed to be inclined, a flow amount of air introduced from the rear of the second fan 180 can be increased, thereby improving heat dissipation performance. In addition, when the outer surface 161b of the heat exchanger 161 facing the second blade 182 is formed to be inclined, a flow amount of air flowing into the second fan 180 can be increased, thereby improving heat dissipation performance.

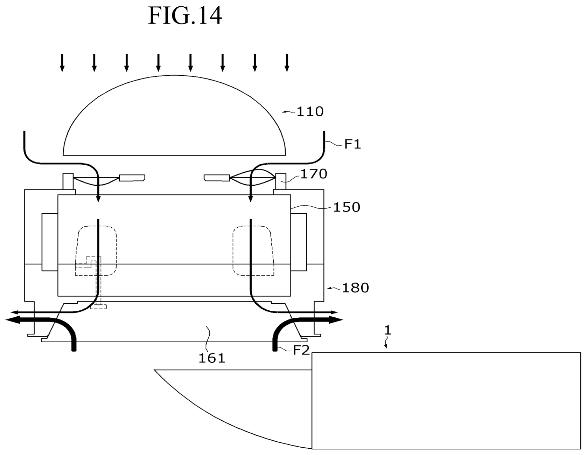

FIG. 14 is a view illustrating an example of an airflow in the propulsion unit 100 when a mobility apparatus takes off.

Referring to FIG. 14, when the mobility apparatus takes off, the propulsion unit 100 can tilt so that the axial direction becomes vertical to make the propulsion unit 100 upright. When the mobility apparatus takes off, a large output of the propulsion unit 100 may be consumed. As the output of the propulsion unit 100 increases, much heat is generated inside the propulsion unit 100. In this case, like an airflow F1 of FIG. 14, air introduced by the first fan 170 is provided to the heat exchanger 161 and exchanges heat with the coolant in the heat exchanger 161. **In** addition, since the propulsion unit 100 tilts, the rear of the heat exchanger 161 is in an open state. In this way, a large amount of air can flow into the heat exchanger 161 through an open space. Since the coolant can be quickly cooled through the large amount of air flowing into the heat exchanger 161, even when much heat is generated inside the propulsion unit 100, a heat dissipation effect can be increased.

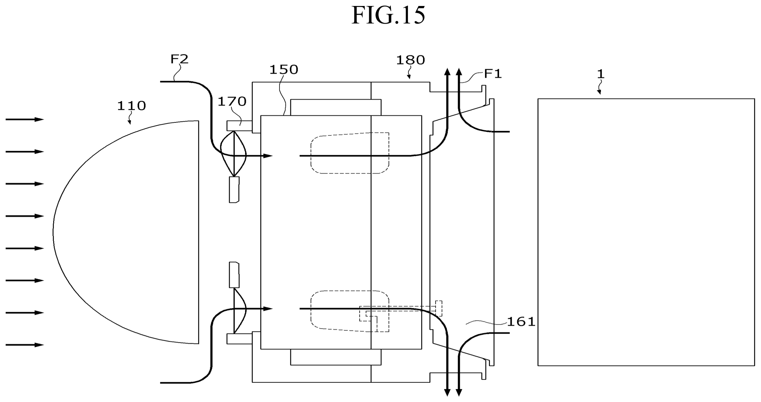

FIG. 15 is a view illustrating an example of an airflow in the propulsion unit 100 when a mobility apparatus cruises.

Referring to FIG. 15, when the mobility apparatus takes off and then cruises, the propulsion unit 100 can re-tilt so that the axial direction becomes horizontal to make the propulsion unit 100 lie. When the mobility apparatus flies (e.g., cruises), less power is consumed than when taking off, and thus relatively less heat is generated inside the propulsion unit 100. In this case, like an airflow F1 of FIG. 15, the air introduced by the first fan 170 is provided to the heat exchanger 161 and exchanges heat with the coolant in the heat exchanger 161. In addition, since the propulsion unit 100 lies, the rear of the heat exchanger 161 is in a closed state. In this way, in the closed space, like F1 of FIG. 15, the amount of air flowing into the heat exchanger 161 is relatively smaller than an upright state of the propulsion unit 100. Although the amount of the air flowing into the heat exchanger 161 is small, the heat dissipation effect can be sufficiently secured because the heat inside the propulsion unit 100 is relatively small.

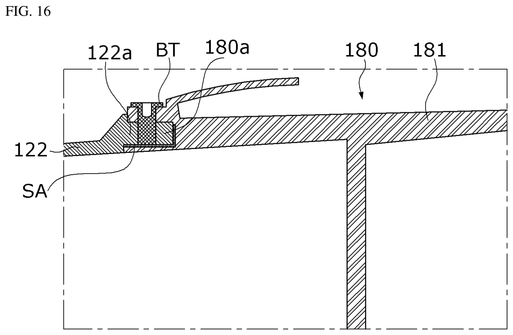

FIG. 16 is a view illustrating an example of a coupling relationship between the yoke 122 and the second fan 180.

Referring to FIG. 16, the yoke 122 and the second fan 180 can be physically fastened through a fastening member BT. When the yoke 122 and the second fan 180 are fastened and the fastening structure protrudes outward in the radial direction due to the fastening structure, drag loss can occur. The fastening structure of the yoke 122 and the second fan 180 for preventing the drag loss is as follows.

The yoke 122 can include a convex portion 122a, the second fan 180 can include a concave portion 180a, and the convex portion 122a and the concave portion 180a can be fastened through the fastening member BT while overlapping each other in the radial direction. The convex portion 122a can protrude from one end of the yoke 122 in the axial direction. The concave portion 180a can be concavely formed in one end of the second fan 180 in the axial direction. One end of the yoke 122 and one end of the second fan 180 in the axial direction are positioned to face each other. As the fastening member BT fastens the concave portion 180a and the convex portion 122a in the radial direction, the second fan 180 can be fixed to the yoke 122 to rotate together. A plurality of fastening structures can be installed at regular intervals in a circumferential direction of the yoke 122.

The fastening structure of the yoke 122 and the second fan 180 can reduce a size of the fastening structure from protruding outward in the radial direction.

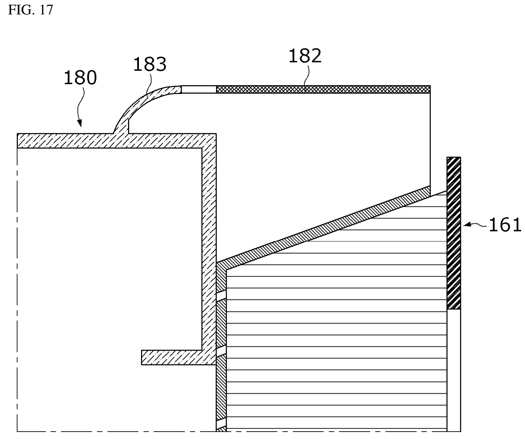

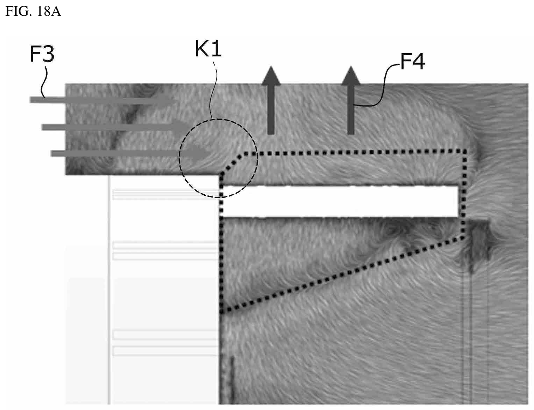

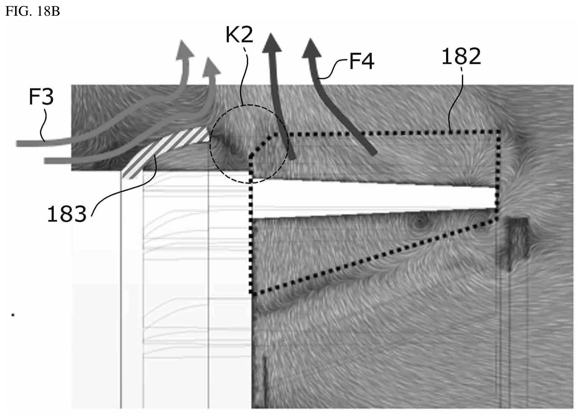

FIG. 17 is a side cross-sectional view illustrating an example of the second fan 180 including a front air block 183, and FIGS. 18A and 18B are views illustrating an example of a comparison between an airflow near the second fan 180 without the front air block 183 and an airflow near the second fan 180 with the front air block 183. In FIGS. 18Aand 18B, an area illustrated in blue indicates a relatively low flow rate, and the area illustrated in red indicates a relatively high flow rate.

Referring to FIGS. 17, 18A, and 18B, the second fan 180 can include the front air block 183. Since the heat dissipation performance of the heat exchanger 161 is improved due to a large amount of air flowing into the heat exchanger 161, it can be important to reduce interference of the airflow in the second fan 180. The flow of air introduced from the front along the yoke 122 can interfere with the flow of air near the second fan 180. Like an airflow F3 of FIGS. 18A and 18B, the front air block 183 blocks the flow of air introduced from the front to the periphery of the second fan 180 to reduce the interference of the airflow in the second fan 180.

The front air block 183 can protrude from an outer surface of the second fan hub 181. The overall shape of the front air block 183 can be a ring shape. In addition, the front air block 183 can be formed to have an arch-shaped outer edge. The front air block 183 can be disposed in front of the second blade 182. The front air block 183 can protrude further than the outer surface of the yoke 122 in the radial direction. In addition, the front air block 183 can be formed to overlap at least the second blade 182 in the axial direction.

FIG. 18A illustrates an example of flow of air near the second fan 180 without the front air block 183, and like an airflow F4 of FIG. 18A, an airflow generated by the second fan 180 begins to interfere with a flow F3 of the air introduced from the front of the second blade 182 in an area such as area K1 of FIG. 18A. As a result, as the flow rate of air guided by the second fan 180 decreases, the flow rate of air flowing into the heat exchanger 161 decreases, and heat dissipation performance degrades.

FIG. 18B illustrates an example of flow of the air near the second fan 180 with the front air block 183, and since the flow F3 of air introduced from the front of the second blade 182 is blocked by the front air block 183, the airflow by the second fan 180 is not interfered with in an area such as area K2 of FIG. 18A. Accordingly, the flow rate of air guided by the second fan 180 is sufficiently secured, and the flow rate of air flowing into the heat exchanger 161 increases, thereby improving heat dissipation performance.

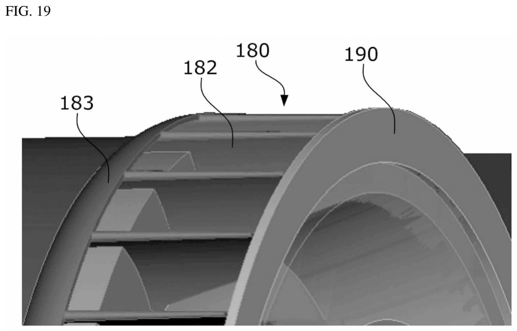

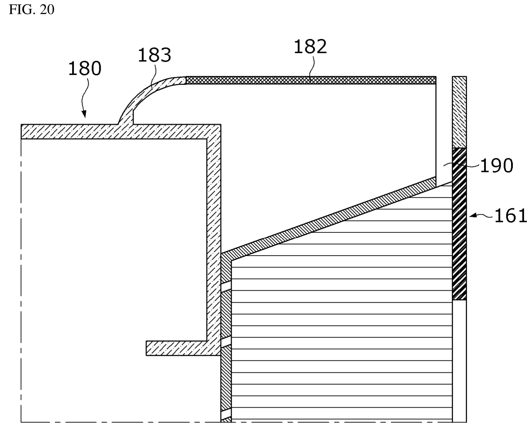

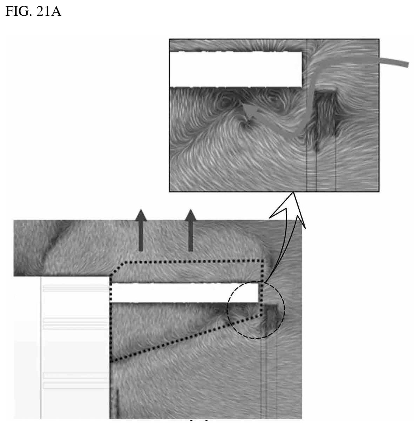

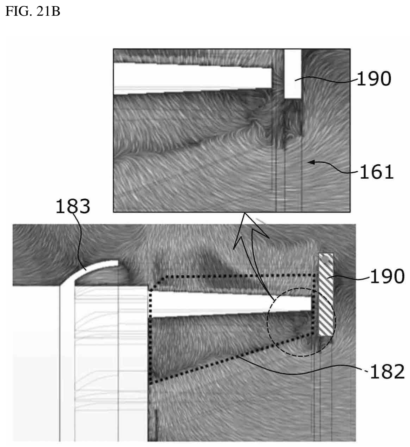

FIG. 19 is a view illustrating an example of a partial area of the second fan 180 including a rear air block 190, FIG. 20 is a side cross-sectional view illustrating an example of the second fan 180 including the rear air block 190, and FIGS. 21A and 21B are views illustrating a comparison between an airflow near the second fan 180 without the rear air block 190 and an airflow near the second fan 180 with the rear air block 190. In FIGS. 21A and 21B, an area illustrated in blue indicates a relatively low flow rate, and the area illustrated in red indicates a relatively high flow rate.

Referring to FIGS. 19 to 21, the second fan 180 can include the rear air block 190. The flow of air directly flowing into the second blade 182 from the rear of the heat exchanger 161 can interfere with the flow of air near the second fan 180. The rear air block 190 blocks the flow of air directly flowing into the second blade 182, thereby reducing interference of the flow in the second fan 180.

The rear air block 190 can be mounted on the heat exchanger 161. The rear air block 190 can be coupled to an outer edge of the heat exchanger 161 in the radial direction. The overall shape of the rear air block 190 can be a ring shape. The rear air block 190 can be disposed behind the second blade 182. In addition, the rear air block 190 can be formed to overlap the second blade 182 in the axial direction. The rear air block 190 is disposed just behind the second blade 182 to block the flow of air flowing from the rear of the second blade 182 to the second blade 182.

FIG. 21A illustrates the flow of air near the second fan 180 without the rear air block 190, and air directly flows into the second blade 182 from the rear of the second blade 182 and thus interferes with the airflow near the second blade 182. As a result, as the flow rate of air guided by the second fan 180 decreases, the flow rate of air flowing into the heat exchanger 161 decreases, and heat dissipation performance deteriorates.

FIG. 21B illustrates the flow of air near the second fan 180 with the rear air block 190, and air flowing into the second blade 182 from the rear of the second blade 182 is blocked by the rear air block 190 and thus does not interfere with the airflow by the second fan 180. Accordingly, the flow rate of air guided by the second fan 180 is sufficiently secured, and the flow rate of air flowing into the heat exchanger 161 increases, thereby improving heat dissipation performance.

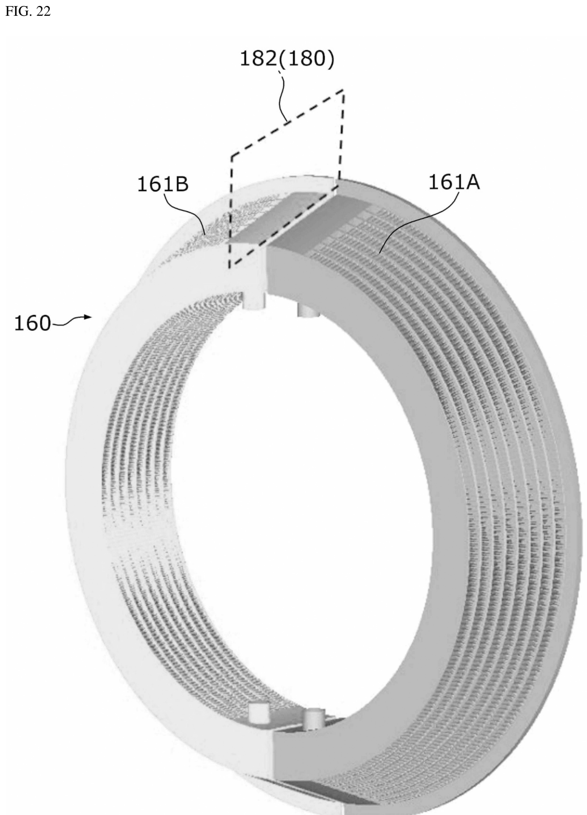

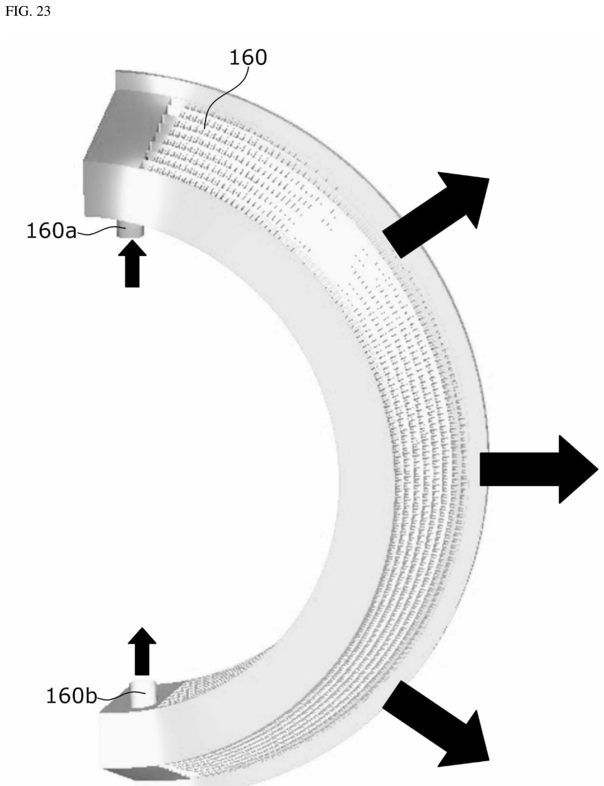

FIG. 22 is a view illustrating the heat exchanger 161, and FIG. 23 is a view illustrating a flow of coolant and a flow of air in the heat exchanger 161.

Referring to FIGS. 22 and 23, the heat exchanger 161 can be formed in a dual manner. The heat exchanger 161 can include a ring-shaped first heat exchanger 161A and a ring-shaped second heat exchanger 161B. The first heat exchanger 161A can be connected to one of the two cooling channels, and the second heat exchanger 161B can be connected to the other of the two cooling channels CH. Coolant can circulate independently in the first heat exchanger 161A and the second heat exchanger 161B. Two cooling loops in which the coolant exchanges heat generated by the rotor 120, the stator 130, and the inverter 140 through the first heat exchanger 161A and the second heat exchanger 161B can be implemented. For example, when one of the two cooling loops fails, cooling can be performed through the other cooling loop.

The heat exchanger 161 can include an inlet 160a and an outlet 160b that are connected to the cooling channels CH. Coolant supplied from the cooling channels CH and heated is introduced through the inlet 160a. The coolant flowing into the inlet 160a is cooled by heat exchange with the air passing through the heat exchanger 161. Air passing through the heat exchanger 161 flows in the radial direction of the heat exchanger 161. The cooled air is supplied to the cooling channels CH through the outlet 160b.

In some implementations, since a heat exchanger is formed integrally with a rotor and disposed just behind the rotor, it is possible to reduce the size and weight of a propulsion unit.

In some implementations, the heat exchanger is disposed just behind the rotor and disposed to overlap a cooling housing in an axial direction, and thus aerodynamically smooths a flow on a surface of the propulsion unit, thereby greatly reducing drag loss of a mobility apparatus.

In some implementations, since the heat exchanger is positioned adjacent to the cooling housing, air passing through the cooling housing can be guided to directly flow into the heat exchanger, thereby greatly improving heat-dissipation performance.

Although the present disclosure has been described above with reference to example embodiments, those skilled in the art will understand that the present disclosure can be modified and changed variously without departing from the spirit and scope of the present disclosure as described in the appended claims.

## Claims

1. A propulsion unit comprising:
a stator;
a rotor configured to rotate relative to the stator;
an inverter electrically connected to the stator;
a cooling housing that is disposed adjacent to the stator and the inverter and defines a cooling channel;
a heat exchanger connected to the cooling channel; and
one or more fans coupled to the rotor and configured to generate airflow toward the heat exchanger through the cooling housing.

2. The propulsion unit of claim 1, wherein the one or more fans comprise:
a first fan coupled to a first side of the rotor in an axial direction of the rotor, and
wherein the first fan and the cooling housing define a first portion of an airflow path toward the heat exchanger.

3. The propulsion unit of claim 2, wherein the one or more fans further comprise:
a second fan coupled to a second side of the rotor in the axial direction, and
wherein the second fan and the cooling housing define a second portion of the airflow path toward the heat exchanger.

4. The propulsion unit of claim 1, wherein the one or more fans comprise:
a first fan coupled to a first side of the rotor in an axial direction of the rotor; and
a second fan coupled to a second side of the rotor in the axial direction, and
wherein the first fan, the cooling housing, and the second fan define an airflow path toward the heat exchanger.

5. The propulsion unit of claim 4, wherein the first fan, the cooling housing, and the second fan are arranged successively along the axial direction.

6. The propulsion unit of claim 1, wherein the cooling housing comprises:
a hub;
a rim portion disposed radially outside the hub; and
an arm portion that connects the hub to the rim portion, and
wherein the cooling housing defines an airflow path including an internal space that borders the hub, the rim portion, and the arm portion.

7. The propulsion unit s of claim 6, wherein the cooling channel is defined in the rim portion.

8. The propulsion unit of claim 2, wherein the first fan overlaps with the cooling housing along the axial direction.

9. The propulsion unit of claim 2, wherein the first fan overlaps with the heat exchanger along the axial direction.

10. The propulsion unit of claim 4, wherein the rotor comprises:
a shaft;
a yoke coupled to the shaft; and
a magnet disposed at the yoke, and
wherein the first fan is coupled to the shaft and configured to rotate with the shaft of the rotor.

11. The propulsion unit of claim 10, wherein the shaft comprises:
a shaft body; and
a flange that extends from the shaft body in a radial direction of the shaft, and
wherein the first fan is fastened to the flange of the shaft.

12. The propulsion unit of claim 4, wherein the second fan overlaps with the heat exchanger along a radial direction of the rotor.

13. The propulsion unit of claim 4, wherein an inner surface of the heat exchanger is inclined radially outward as the heat exchanger extends in the axial direction.

14. The propulsion unit of claim 12, wherein the heat exchanger is positioned inside the second fan in the radial direction.

15. The propulsion unit of claim 10, wherein the second fan is coupled to the yoke.
